# EUROPEAN PATENT SPECIFICATION

(11) **EP 4 355 052 B1**
(45) Date of publication and mention of the grant of the patent: **29.04.2026**
(21) Application number: 23465550.4
(22) Date of filing: 10.10.2023
(51) Int. Cl.: H10K 50/10, H10K 50/816, H10K 50/828, H10K 77/10, H10K 101/10, H10K 102/00

(54) **TRANSPARENT AND FLEXIBLE MULTILAYER DIODE DEVICE BASED ON ELECTROSPUN POLYMER FIBERS AND ORGANOMETALLIC COMPOUNDS AND PROCESS FOR MANUFACTURING SUCH DEVICE**
TRANSPARENTE UND FLEXIBLE MEHRSCHICHTDIODENVORRICHTUNG AUF BASIS VON ELEKTROGESPONNENEN POLYMERFASERN UND ORGANOMETALLISCHEN VERBINDUNGEN UND VERFAHREN ZUR HERSTELLUNG EINER SOLCHEN VORRICHTUNG
DISPOSITIF À DIODE MULTICOUCHE TRANSPARENTE ET FLEXIBLE À BASE DE FIBRES POLYMÈRES ÉLECTROFILÉES ET COMPOSÉS ORGANOMÉTALLIQUES ET PROCÉDÉ DE FABRICATION D'UN TEL DISPOSITIF

(30) Priority: 12.10.2022 RO 202200626
(43) Date of publication of application: 17.04.2024
(73) Proprietor: Institutul National de Cercetare-Dezvoltare pentru Fizica Materialelor-INCDFM Bucuresti, Magurele (RO)
(72) Inventor: CIOBOTARU, Iulia Corina, 077060 Clinceni, jud.Ilfov (RO); CIOBOTARU, Constantin Claudiu, 051176 Bucharest (RO); EVANGHELIDIS, Alexandru, 050882 Bucharest (RO); POLOSAN, Silviu Pavel, 077129 Magurele,Varteju, jud Ilfov (RO); ENCULESCU, Ionut Marius, 115300 Curtea de Arges, jud Arges (RO); CASARICA, Angela, 031451 Bucharest (RO)
(74) Representative: Munteanu, Manuela-Cornelia

(56) References cited:
- WO-A1-2016/159639
- CIOBOTARU IULIA CORINA ET AL: "Charge transport mechanisms in free-standing devices with electrospun electrodes", NANOTECHNOLOGY, INSTITUTE OF PHYSICS PUBLISHING, BRISTOL, GB, vol. 33, no. 39, 7 July 2022 (2022-07-07), XP020456036, ISSN: 0957-4484, [retrieved on 20220707], DOI: 10.1088/1361-6528/AC7AC1
- CIOBOTARU I C ET AL: "Dual emitter IrQ(ppy)2for OLED applications: Synthesis and spectroscopic analysis", JOURNAL OF LUMINESCENCE, ELSEVIER BV NORTH-HOLLAND, NL, vol. 145, 3 August 2013 (2013-08-03), pages 259 - 262, XP028770525, ISSN: 0022-2313, DOI: 10.1016/J.JLUMIN.2013.07.067
- VEERAMUTHU LOGANATHAN ET AL: "Human Skin-Inspired Electrospun Patterned Robust Strain-Insensitive Pressure Sensors and Wearable Flexible Light-Emitting Diodes", vol. 14, no. 26, 24 June 2022 (2022-06-24), US, pages 30160 - 30173, XP093129210, ISSN: 1944-8244, Retrieved from the Internet <URL:https://pubs.acs.org/doi/pdf/10.1021/acsami.2c04916> DOI: 10.1021/acsami.2c04916

## Description

### TECHNICAL FIELD OF THE INVENTION

The present invention relates to a transparent and flexible organic multilayer diode device comprising electrospun polymethyl methacrylate fibers, polyvinylcarbazole as hole transport layer and (8-hydroxyquinoline bis(2-phenylpyridyl) iridium (III) complex as an emissive layer, on a flexible substrate, with applications in electronic displays, wearable systems and photodetectors, and a process for manufacturing such device.

### BACKGROUND OF THE INVENTION

Organic light-emitting diodes (OLEDs) have unique characteristics, including low power consumption, high efficiency, wide viewing angle, and high response speed, enabling the development of highly portable and flexible devices. Many research efforts focus on creating fiber networks to replace traditional thin films in high-performance, next-generation devices such as electroluminescent diodes, touchscreens, solar cells, skin-like sensors and smart windows. However, the fabrication of a multilayer network composed of transparent nanofibers is a challenging task. These features are based exclusively on the unique properties of their component materials.

Transparent and flexible metal electrodes play a crucial role in organic electroluminescent diode technology, due to their exceptional electrical and optical properties. The current state-of-the-art process of fabricating an electroluminescent diode typically involves metallized electrospun nanofibers as electrodes, obtained through separate processing steps and finally attached as the last layer of the diode. Representative inventions related to transparent electrodes using nanofibers involve the electrospinning process combined with various metallization processes. For instance, in patent application number WO2016159639A1, Yoon Suk Goo and al. use electrospinning to create a nanofiber web, which is then electroplated with metals such as Au and Pt to create transparent electrodes. Choi and co-workers ("Junction-Free Electrospun Ag Fiber Electrodes for Flexible Organic Light-Emitting Diodes", Small, 2018,14 1702567, *"*Ag fiber/IZO Composite Electrodes: Improved Chemical and Thermal Stability and Uniform Light Emission in Flexible Organic Light- Emitting Diodes", Scientific Reports (2019) 9:738) used electrospun polystyrene fibers on a silver film deposited on a flexible polyethylene naphthalate substrate, followed by plasma etching and hydrogen peroxide immersion of the silver film to obtain the transparent metallic electrode used as anode in the organic electroluminescent device. Kim II Doo (patent no. KR101995096B1) utilized a similar approach to produce a colourless, transparent, flexible polyimide substrate with a high heat-resistant, smooth surface structure. This was achieved by incorporating a belt-like metal electrode wire (either nanobelt or microbelt) within the transparent electrode of the substrate. The result was a transparent electrode with high heat resistance and excellent flexibility. Many research studies have focused on metallic nanowire networks, such as AgNWs. These networks are usually created by a solution process, described in patent application no. WO2019078406A1, patent no. US1098340382, and in reviews by Langley D et al. titled "Flexible transparent conductive materials based on silver nanowire networks: a review" published in Nanotechnology, 2013 Nov 15;24(45):452001 and by Nguyen VH, et al. titled "Advances in Flexible Metallic Transparent Electrodes", published in Small, 2022 May;18(19).

Jinhwan Lee and his team, in their research article "A dual-scale metal nanowire network transparent conductor for highly efficient and flexible organic light emitting diodes", published in the journal Nanoscale in 2017 (5), synthesized two different-sized silver nanowires (AgNWs) using a modified polyol process. They then developed a dual-scale AgNW network transparent conductor, using these two different-sized AgNWs, for application in a highly efficient flexible phosphorescent OLED. To fabricate the dual-scale AgNW-based transparent conducting films (TCFs), the nanowires were dispersed through a bar-coating process on a heated glass substrate, which induced rapid vaporization of the NW solvent while maintaining a uniform and thin layer of the conducting film. Afterwards, they used a laser ablation process to remove the AgNWs from the surface without causing any noticeable damage to the substrate. Finally, the patterned TCF for OLEDs was transferred from glass donor substrates to flexible substrates using a curing and peel-off method.

Other examples of solution-processing electrodes relate to mixing metallic nanoparticles and polymer material to form a network on the substrate spinning step. This was described by Kim Hyo Sung et al in patent no. KR102324666B1 and by Yuqiang Liu et al. in their paper "Flexible organic light-emitting diodes fabricated on biocompatible silk fibroin substrate", published in Semicond. Sci. Technol. 30 104004 in 2015. These networks offer excellent optical and electrical properties, high flexibility, conformable deposition, and stretchability. Sannicolo T, et al. described these breakthrough aspects in their review "Metallic Nanowire-Based Transparent Electrodes for Next Generation Flexible Devices: a Review", published in Small in November 2016, Volume 12, Issue 44, Pages 6052-6075.

Transparent conducting electrodes used in OLED or touch screen applications can be composed of metallic nanofiber networks produced through electrospinning and standard thin-film deposition techniques such as thermal evaporation, electron-beam evaporation, or magnetron sputtering. A study by Hui Wu et al, titled "A transparent electrode based on a metal nanotrough network", published in Nature Nanotechnology, reveals that using metallic nanofiber networks can be highly effective for producing transparent electrodes. Recently, I.C. Ciobotaru et al ("Organic Light-Emitting Diodes with Electrospun Electrodes for Double-Side Emissions", Micromachines 2023, 14(3), 543) fabricated OLEDs with electrospun electrodes based on polymethylmethacrylate/gold nanofibers used as cathodes through the electrospinning technique and gold sputtering (top-down method). In this study, the obtained gold nanofiber electrodes were placed on the top surface of the OLED light-emitting layer through thermal transfer to create the charge injection in the device structure and enable double-side emission.

He Xiaolong et al, in their patent no. US2016301024A1, titled *"Organic electroluminescent device, method of preparing same, display substrate, and display apparatus",* have introduced an alternative method for creating an electroluminescent display using the electrospinning process. Their invention combines an organic solvent, a charge control agent, an electroluminescent polymer, and quantum dots uniformly to obtain an electrostatic spinning solution. This solution can create a quantum dot-containing organic electroluminescent film through an electrostatic spinning process.

Metal nanowires are usually produced through a solution process, which can result in high production costs due to the numerous processing and post-treatment steps. These steps include thermal annealing, mechanical pressing, plasmonic welding, and encapsulations, all necessary to weld the contacting nanowires. Furthermore, metal nanowires may have poor thermal or chemical stability and poor electrical conductivity due to the presence of aggregates in solution, and may affect charge carrier injection and transport in the device. On the other hand, the top-down method involves depositing a metal film onto a template or mask to form a fully interconnected network without any wire-wire junction resistance. However, this technique requires an additional thermal transfer step on top of the last device layer, which can limit the polymer type used in the electrospinning process.

Organometallic compounds are formed from a central metal ion bonded to three or more identical or different organic ligands. The role of these compounds in an organic light-emitting diode structure is based on electroluminescence (EL) in the emissive layer through the recombination of the positive and negative charges when a voltage is applied to the electrodes of the OLED device. In OLED devices, many materials that emit light are useful due to their excited singlet state by fluorescence. When excitons are formed in an OLED device, they transfer their energy to the excited state of a light-emitting dopant, creating the excited singlet state. However, research has shown that only 25% of the excitons created in an electroluminescent device are singlet excitons. The remaining 75% are triplet excitons, which cannot transfer their energy efficiently to the singlet excited state of a dopant. As a result, this leads to a significant loss in efficiency since most of the excitons are not utilized in the light emission process. Triplet excitons can transfer their energy to a dopant with a low enough energy level for its triplet excited state. If the dopant's triplet state is emissive, it can produce light through phosphorescence (Baldo et al., "Highly Efficient Phosphorescent Emission from Organic Electroluminescent Devices", Nature, vol. 395, 151-154, 1998; Baldo et al., "Very high-efficiency green organic light-emitting devices based on electrophosphorescence", Appl. Phys. Lett., vol. 75, No. 3, 4-6 (1999). In addition, singlet excitons can also transfer their energy to the dopant's lowest singlet excited state. The singlet excited state can then relax by an intersystem crossing process, leading to the emissive triplet excited state. This means that selecting the right host and dopant makes it possible to collect energy from singlet and triplet excitons in an OLED device and produce a highly efficient phosphorescent emission.

Cyclometallated iridium (III) complexes of IrL3 and IrL2L', where L and **L'** are cyclometallating and ancillary ligands, strongly emit light from a triplet excited state due to the heavy atom's large spin-orbit coupling. Many iridium-based emitting materials useful in OLED devices present single-colour phosphorescence in red (Patent No. CN114478643A, No. KR20050003734A, No. KR100564918B1, No. CN107586308A), green (Patent No. KR20050005084A, No. CN109970808A, No. US2014103316A1, no. US2022209139A1), and blue (Patent No. US2006228578A1, US 20040068132A1, No. US 2004/0048101, B. W. D'Andrade, J.-Y Tsai, C. Lin, M. S. Weaver, P. B. Mackenzie, J. Brown, "Efficient White Phosphorescent Organic Light-Emitting Devices" SID Symposium Digest, Vol. 38, pp. 1026-1029, 2007, J. Li, P. I. Djurovich, B. D. Alleyne, M. Yousufuddin, N. N. Ho, J. C. Thomas, J. C. Peters, R. Bau, M. E. Thompson, "Synthetic Control of Excited-State Properties in Cyclometalated Ir(III) Complexes Using Ancillary Ligands", Inorg. Chem., Vol. 44, pp. 1713-1727, 2005).

In a study by I.C. Ciobotaru and team (I. C. Ciobotaru et al. "Dual emitter IrQ(ppy)2 for OLED applications: Synthesis and spectroscopic analysis", Journal of Luminescence, ELSEVIER BV NORTH-HOLLAND, NL 145, 259-262, 3 August 2013), the complex IrQ(ppy)₂, containing Ir(III), 8-hydroxyquinoline (Q), and bis 2-phenyl pyridyl (ppy) was synthesized. The complex exhibits phosphorescence with two peaks. The peak at 530 nm arises from the Ir-ppy part, while the peak at 635 nm arises from the Ir-Q part. The phosphorescence is excited at 285 nm and originates from the spin-triplet state to the singlet ground state. This compound has the unique advantage of emitting red and green light from a single molecule. Furthermore, it exhibits high spin-orbit coupling and electron mobility, which enhances charge transport and emission.

The IrQ(ppy)₂, have been used in organic electroluminescent diode technology by S. Polosan and al., as was described in the paper "Organometallic Coatings for Electroluminescence Applications", Coatings 2020, 10(3), 277. In this study, the emission layer consisting of poly(9-vinylcarbazole) (PVK) polymer or 4,4'-Bis(9-carbazolyl)-1,1'-biphenyl, 4,4-*N*,*N*-Oicarbazole-1,1'-biphenyl (CBP) small molecule and IrQ(ppy)₂ dissolved in chloroform as host-guest systems, and then spin-coated as thin films on the glass/ITO/PEDOT-PSS substrates. The electroluminescence can be increased in the CBP small-molecule layer by altering the applied voltage. However, substituting CBP with a conductive polymer such as PVK results in no variation in electroluminescence with applied bias, indicating different aggregation mechanisms in these active layers.

Fabricating electroluminescent diodes using organometallic compounds as the light-emitting layer requires optimizing the electric charge injection or transport of these charges in the diode's multilayer structures. Measuring the current-voltage characteristics of electroluminescent diodes can provide valuable insights into charge carrier injection and transport mechanisms. These characteristics usually follow an exponential form, indicating a "hopping" conduction mechanism. The size of the exponent in the current-voltage dependence can help conclude the type of injection regime. Quadratic voltage dependence indicates a space charge limited current, and an exponent greater than 2 indicates a space charge limited current due to charge capture centers.

In their study published in Nanotechnology Institute of Physics Publishing, Bristol, GB, (volume 33, number 39, 7 July 2022), I.C. Ciobotaru and colleagues investigated the charge transport mechanisms in simple devices with the structure PMMA/Au/Alq₃/LiF/Al. The researchers evaluated the electrical performance of these devices, specifically the electron drift mobility, which greatly affects the charge transport across the structures. To improve the mechanical durability of the fiber-based structures, they were transferred onto transparent PET substrates. The current-voltage curves of the devices exhibited the three classical zones observed in other OLED devices, but with substantially lower applied voltages than similar thin-film-based OLEDs.

In other studies like "Human Skin-Inspired Electrospun Patterned Robust Strain-Insensitive Pressure Sensors and Wearable Flexible Light-Emitting Diodes" from ACS Applied Materials & Interfaces, (Vol 14/Issue 26 from 24 june 2022), the authors described a flexible PFO OLED device fabrication procedure, which is entirely solution-processable. This device includes P-PDMS and PP-PDMS substrates as thin films obtained by the drop-casting of a PDMS solution onto the PVA nanofibrous mat structure obtained by electrospinning followed by the spin-coating deposition from a solution of the PEDOT:PSS and PEO. The emission layer (PFO) was also deposited by spin-coating from the solution. The resulting device was completed by adhering to the EGaln metal electrode on top. This fabrication procedure will lead to obtaining a single-side emission device because the EGaln metal electrode is not transparent, as we can notice from Figure 6 e, f. and the authors do not mention the transparency of the final OLED device.

### SUMMARY

Notwithstanding these developments, there is still a need for a flexible and transparent electroluminescent diode that provides dual emission on the same molecule and double-side emission through the optical transmission of the electrospun polymer fiber network.

To address the aforementioned issues and to eliminate the additional step of electrode processing, the patent provides the solution of furnishing a transparent and flexible organic multilayer diode device, which comprises: an electrospun polymethyl methacrylate (PMMA) fiber network layer substrate, and on this substrate, arranged in the following sequence: a metallic anode layer, a polyvinylcarbazole (PVK) hole transport layer, a (8-hydroxyquinoline bis(2-phenyl pyridyl) iridium (IrQ(ppy)₂) organometallic light emitting layer, a lithium fluoride buffer layer, and a cathode layer.

All adjacent layers to the polymer fiber network have a defined geometrical configuration to prevent electrical leakage in the final device. In particular, the electrospun PMMA fiber'network layer substrate has a thickness between 0.7-1.5 µm and an optical transmission of 70-90%, the metallic anode layer has a thickness between 50-100 nm, the PVK hole transport layer has a thickness between 40-60 nm, the IrQ(ppy)₂ organometallic light emitting layer has a thickness between 50-80 nm, the lithium fluoride buffer layer has a thickness between 0.8 - 1.5 nm, the cathode layer is Al and has a thickness between 100-150 nm.

The advantage of this sandwich structure is that it can be attached to flexible transparent substrates, such as plastics or bacterial cellulose.

An additional benefit arising from integrating this organic multilayer device is its capability to exhibit diode-like characteristics when voltage is applied. Such characteristics are crucial in various applications within electronic display technology. By virtue of the electrospun polymer fiber's optical transmission property, the device offers enhanced transparency and flexibility, which are notable advantages.

In the claimed invention, the material for the electrospun polymer fiber network layer substrate is polymethyl methacrylate. Due to the use of polymethyl methacrylate, the layer can be transparent and ensures emission on both sides of the diode device.

Examples of other polymers that can be deposited by electrospinning and then attached to flexible substrates by different procedures are: Nylon, Polycaprolactone (PCL), polyurethane (PU) These polymers are not forming part of the claimed invention.

The optical transparency is given by the density of fibers that make up the electrospun network, which influences the thickness of the supporting fiber layer. In the claimed invention, the polymethyl methacrylate fiber network layer has a thickness between 0.7-1.5 µm and an optical transmission of 70-90%.

In a preferred embodiment the material for the metallic anode layer is selected from an Au, Ag, Ni or ITO.

In the claimed invention, the metallic anode layer has a thickness between 50-100 nm.

Anodes are picked based on the quality of their optical transparency, electrical conductivity, and chemical stability. They must have a high work function near the Highest Occupied Molecular Orbital level (HOMO) of the Hole Transport Layer (HTL), which promotes the injection of holes into the HOMO level of the organic layer.

Some examples could include gold, silver, nickel and indium tin oxide (ITO, a semimetal).

The HOMO level of the HTL generally lies between the work function of the anode and the HOMO of the next layer (in this case, the emissive layer), reducing the energy barriers for the hole transport layer.

The thickness of the anode layer **is** between: 50-100 nm;

The incorporation of a hole transport layer contributes to reduced drive voltage requirements and enhanced operational stability, further underscoring the advantageous features of this innovation.

In the claimed invention, the material for the polymer hole transport layer is Polyvinylcarbazole (PVK), examples of other materials for the polymer hole transport layer, which are not forming part of the claimed invention, are: poly(3,4-ethylene dioxythiophene) polystyrene sulfonate (PEDOT-PSS), N, N'-Bis(3-methyl phenyl)-N, N'-diphenyl benzidine (TPD), N, N'-Di(1-naphthyl)-N, N'-diphenyl-(1,1'-biphenyl)-4,4'-diamine (NPB). The thickness of the HTL layer is between: 40-60 nm;

This invention employs an Ir(III) complex, i.e. (8-hydroxyquinoline bis(2-phenylpyridyl) iridium (III) complex (IrQ(ppy)₂) specifically comprising a central iridium ion bound to two phenylpyridine ligands and one quinoline ligand, providing distinctive attributes to the device.

Thanks to the photoluminescent properties of this compound, the multilayer diode device achieves dual emission in red and green wavelength regions. Additionally, the device has the ability to emit light from both sides, taking advantage of its transparency.

In the claimed invention, the thickness of the Ir(III) complex (8-hydroxyquinoline bis(2-phenylovridyl) iridium organometallic emitting layer is between 50-80 nm.

A device configuration with an electrospun PMMA network support, metallic gold/silver anode, PVK hole transport layer, IrQ(ppy)₂ dual green-red light-emitting layer, lithium fluoride as a buffer layer and aluminum as the cathode, provides a device that is capable of dual emission on the same molecule and double-side emission through the optical transmission of the electrospun polymer fiber network.

The layers must fulfil specific requirements to achieve high efficiency (emitted photons per injected electrons).

Thin inorganic materials as buffer layers (e.g. lithium fluoride (LiF)) are used to promote efficient electron injection towards the emissive layer.

In the claimed invention, the thickness of the LiF layer is between 0.8 - 1.5 nm;

The cathode is responsible for electron generation and should be characterized by a low electron work function.

Such materials include alkaline earth metals and other active metals such as aluminum.

In the claimed invention, the material of the cathode layer is AI, which has a thickness between 100-150 nm.

Finally, this structure configuration permits easy attachment onto various flexible substrates, rendering it highly versatile and suitable for a broad spectrum of applications.

Examples of materials of flexible substrates on which the diode device can be transferred include: Polyethylene terephthalate (PET), Polyethylene naphthalate (PEN), Poly-dimethyl siloxane (PDMS), polyimides (PI) (transparent and flexible polymers in general), bacterial cellulose and paper.

In another preferred embodiment, the flexible transparent substrate is selected from polyethene terephthalate or bacterial cellulose.

In another aspect of the invention, a process for manufacturing the claimed diode device is provided. The process for manufacturing the claimed diode device comprises the following steps:
- providing a stainless-steel frame collector on which a multilayer sandwich structure is built in the following sequence:
   - providing an electrospun polymer fiber network layer substrate on top of the collector by an electrospinning process, using a precursor polymer solution;
   - depositing a first metallic layer on one side of the electrospun polymer fiber network layer substrate through a shadow mask, partially covering the electrospun fiber network layer substrate, as a metallic anode layer;
   - depositing a polymer hole transport layer made of polyvinylcarbazole (PVK), on the first metallic layer, through a shadow mask, partially covering the first metallic layer;
   - depositing (8-hydroxyquinoline bis(2-phenyl pyridyl) iridium (IrQ(ppy)₂) organometallic light emitting layer on the PVK hole transport layer, by thermal evaporation, through a shadow mask, over the same overlapping surface as of the PVK hole transport layer surface,
   - depositing a buffer layer of lithium fluoride, on the iridium organometallic emitting layer, through a shadow mask, partially overlapping the emitting layer,
   - depositing a second metallic layer, over the same overlapping surface area of the buffer lithium fluoride layer surface, through a shadow mask, to serve as a metallic cathode layer and removing the stainless-steel frame collector.

The advantage of using the electrospinning process for the polymer fiber preparation and layer deposition in the same batch is that it lowers the fabrication costs.

The method of depositing IrQ(ppy)₂ dual green-red light-emitting layer through thermal evaporation from powder, rather than the host-guest solution processing ensures a uniform surface across the entire fiber adjacent layers and allows for a dual emission from a single evaporation step. Consequently, the cost of preparing the device is significantly reduced.

The multilayer sandwich structure is designed to ensure efficient charge injection and transport. As a result, the devices could achieve longer lifetimes and higher emission efficiency. Each shadow mask should overlap the anode pattern to create the desired pixel areas and to ensure the electrical connection to the electrodes (anode and cathode).

The size of the pixels must be optimal to have low energy consumption.

The process for manufacturing the diode device can further comprise, before the step of removing the stainless-steel frame collector the intermediate steps of:
- heating a flexible transparent substrate at 130-170°C;
- attaching the flexible transparent substrate to the electrospun polymer fiber network layer substrate;
- maintaining at the same temperature above, for 5 minutes, the heating of the attached flexible transparent substrate, and

- after removing the stainless-steel frame collector the supplementary step of continue heating the substrate with the attached multilayer sandwich structure at 130-170°C for 10 minutes.

The multilayer sandwich structure to various flexible substrates makes the device suitable for a wide range of applications.

The temperature range at which the transfer can be made depends on the type of polymer used in the electrospinning process. **For** Polymethyl methacrylate (PMMA), the temperature range can be between 130-170°C.

In a preferred embodiment, the first metallic layer is gold, and the depositing method is DC Magnetron Sputtering, with the specific parameters: current: 17 -19 mA, argon flow: 9-11 sccm, pressure: 4.5 - 6 x10⁻³ mbar, and time: 60 - 90 minutes, with a surface-active area of 415 mm², to a thickness of the metallic layer of between: 50 - 100 nm;

The polyvinyl carbazole is deposited through thermal vacuum evaporation eith the specific parameters: pressure 1 - 3 x 10⁻⁶ mbr, current ranging from 50-80 A, voltage ranging from 0.665-1V, and a deposition time of 10-15 minutes.

The thickness of the HTL layer is between: 40-60 nm;

In another preferred embodiment the surface area for depositing the hole transport layer and the emission layer material is 315 mm².

In the claimed invention the deposition method for the Ir(III) complex (8-hydroxyquinoline bis(2-phenyl pyridyl) iridium emissive layer is thermal vacuum evaporation with the specific parameters: pressure of 1-3x10⁻⁶ mbar, current: 52 - 57 A, voltage: 0.6 - 0.7 V, and a deposition time:15-20 minutes.

The deposition is made until the thickness of the emissive layer reaches between: 50-80 nm;

In another preferred embodiment the depositing method for depositing the buffer is thermal vacuum evaporation with the specific parameters: pressure: 1-3x10⁻⁶ mbar, current: 113-120 A, voltage: 0.68 - 0.74 V, and time: 2- 3 minutes; thickness of the LiF buffer layer: 0.8 - 1.5 nm;

Another preferred embodiment method for preparing the cathode layer is thermal vacuum evaporation with the specific parameters: pressure: 1- 3x10⁻⁶ mbar, current: 190-220A, voltage: 1.5-2 V, and time: 10-20 minutes; thickness of the aluminium layer: 100-150 nm.

In another preferred embodiment the surface cathode area is composed of four pixels, with each pixel measuring 48 mm².

In another aspect the invention provides an electronic display comprising a diode device as mentioned above.

### BRIEF DESCRIPTION OF THE DRAWINGS

To clearly illustrate the technical solutions of the embodiments of the present invention, the drawings of the embodiments will be briefly described below.

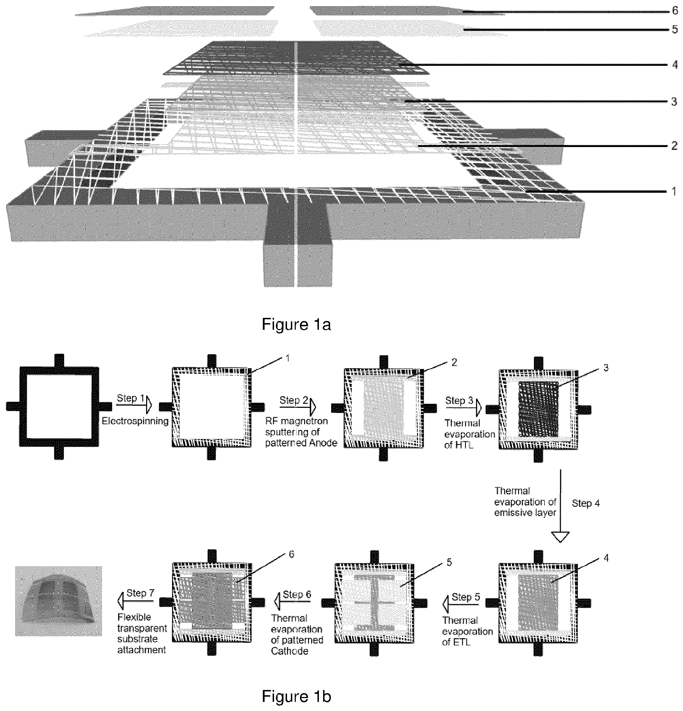

Fig.1.a is a simplified schematic representation (cross-sectional view) of a prototype electroluminescent diode structure in accordance with an embodiment of the present invention;
Fig. 1.b is a simplified scheme of the process of obtaining a flexible organic multilayer diode device and its steps;
Fig. 2. is a graph depicting the luminance spectrum and emission image under 405 nm excitation of the structure obtained after depositing the Ir(III) complex (8-hydroxyquinoline bis(2-phenylpyridyl) iridium organometallic (IrQ(ppy)₂) emissive layer.
Fig. 3. is a graph depicting the current-voltage characteristics of the device obtained in step 7 a) at different applied voltages; b) logarithmic scaling of the curve from 1.4V.
Figure 1a shows an electrospun polymer fiber network layer substrate fixed on a frame collector 1, a metallic anode layer 2, a polymer hole transport layer 3, an Ir(III) complex (8-hydroxyquinoline bis(2-phenylpyridyl) iridium organometallic emissive layer 4, a buffer layer 5 and an aluminium cathode layer 6.

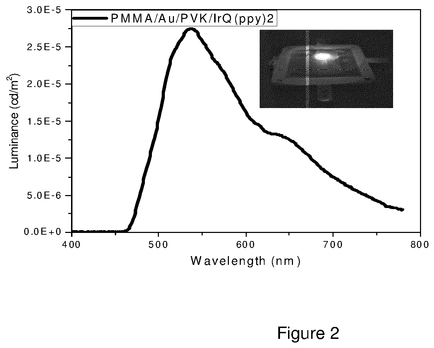

Figure 2 shows the luminance spectrum and the photo image of the fiber network obtained after depositing the IrQ(ppy)₂ emissive layer, by optical excitation with a 405 nm diode. The dual character of the emission specific to the organometallic compound Irq(ppy)₂ can also be observed on the described fiber network by the presence of the two peaks: at 538 nm and 640 nm.

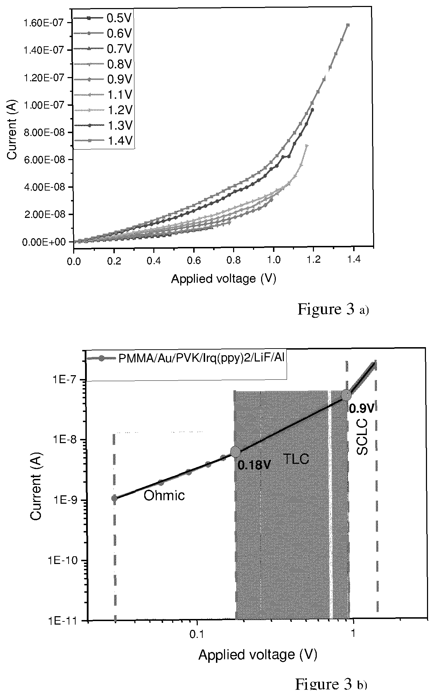

The current-voltage characteristics of organic diodes at various operating voltages are shown in Figure 3. Specifically, Figure 3a displays the current-voltage characteristics at different applied voltages, and Figure 3b shows the conduction mechanisms at the maximum applied voltage by plotting the logarithmic scale of the curve from 1.4 V. In this region, three conduction mechanisms can be observed: the ohmic conduction zone at low voltages (up to 0.18 V), the trapped limited current (TLC) conduction zone between 0.18-0.9 V, and the space charge limited current (SCLC) conduction zone between 0.9-1.4 V where device trapping occurs.

### DETAILED DESCRIPTION OF THE INVENTION

Without limiting the scope of protection, the following embodiments for carrying out the invention are given.

In one embodiment, this invention includes a transparent and flexible organic multilayer diode device that comprises: an electrospun polymethylmethacrylate'(PMMA) fiber network onto a stainless-steel frame collector 1 and the following components that are provided on this substrate from bottom to top in sequence: a gold anode 2, a polyvinylcarbazole (PVK) hole transport layer 3, an (8-hydroxyquinolirie bis(2-phenylpyridyl) iridium (III) complex (IrQ(ppy)₂) organometallic light emitting layer 4, a lithium fluoride buffer layer 5, and an aluminium cathode layer 6. The multilayer sandwich structure can be transferred to a flexible substrate such as PET or bacterial cellulose.

The stainless steel frame collector can have various sizes. The stainless steel frame collector can have larger dimensions, up to 20x20 cm.

The surface area of the anode layer is a surface-active area of 415 mm², partially covering the electrospun fiber network layer substrate.

The surface area for depositing the hole transport layer and the surface area of the emission layer material is totally overlapping over 315 mm² and the cathode area is composed of four pixels, with each pixel measuring 48 mm²;

The multilayer sandwich structure is designed to allow electrical connections.The present invention further provides a method for fabricating a multilayer diode device, comprising the following steps:
**Step (1):** the electrospinning process of the polymethylmethacrylate (PMMA- molecular weight 350,000 g/mol from Sigma Aldrich), precursor solution with a concentration of 10 wt % (gravimetric percent) in dimethylformamide (DMF - 90% from Sigma Aldrich) with the following parameters: spinneret with stainless steel syringe needle, inner diameter 0.8 mm; polymer solution feed rate: 0.5 ml/h; applied voltage on the spinneret: 15 kV; distance between electrodes: 16 cm; working conditions: temperature between 19.8-20 °C, relative humidity 18.3%; collector: stainless steel frame with external size of 4x4 cm and internal size of 3x3 cm.
**Step (2):** a gold layer coating, on one side, of the electrospun fiber network layer substrate, as anode. The anode layer deposition was made through DC Magnetron Sputtering using a mechanical shadow mask with a surface-active area of 415 mm², partially covering the the electrospun fiber network layer substrate. The following parameters were used: current: 18 mA, argon flow: 10 sccm, pressure - 4.5-6 x10 mbar, and time: 90 minutes.
**Step (3, 4):** the successive deposition by thermal vacuum evaporation of the hole transport and emissive layers using a molybdenum boat, over the same overlapping surface. The hole transport layer polyvinylcarbazole (PVK) was deposited through thermal vacuum evaporation with the following parameters: pressure of 2.5 x 10⁻⁶ mbar, current ranging from 50-80 A, voltage ranging from 0.665-1V, and a deposition time of 13 minutes. Following this, the IrQ(ppy)₂ emissive layer was deposited under the following parameters: pressure of 2x10⁻⁶ mbar, current of 55.7 A, voltage of 0.6-0.7 V, and a deposition time of 20 minutes. The surface area of the active layer is approximately 315 mm², partially covering the anod layer.
**Steps (5)** and **(6)** involve depositing the buffer and cathode layers using the same mechanical masks, over the same surface area, to define the device pixels, with each pixel measuring 48 mm², partially overlapping the emitting layer. Lithium fluoride is a suitable material for the buffer layer, while aluminium is a suitable metal for the cathode layer. Both can be thermally evaporated in a vacuum using a tungsten boat. The thermal evaporation parameters for the lithium fluoride powder are pressure: 1-3 x10⁻⁶ mbar, current: 113-120 A, voltage: 0.68-0.74 V, and time 2-3 minutes. For the aluminium cathode, the thermal evaporation conditions are: pressure: 1-3 x10⁻⁶ mbar, current 190- 220 A, voltage: 1.5 -2 V, and time 10-20 minutes. The cathode covers a surface area of four pixels, with each pixel measuring 48 mm².
**Step (7)** involves attaching the polymer fiber network substrate, coated with the layers described above by heating on a flexible polyethylene terephthalate (PET) or bacterial cellulose membrane substrate. The flexible substrate totally covers the polymer fiber network substrate. During the attachment procedure, the substrate needs to be heated to 130-170 °C. Once heated, the stainless-steel frame with the sandwich structure is attached and left to maintain for 5 minutes. Then, the stainless-steel frame should be removed, and the substrate with the attached structure should continue to be heated at the same temperature for 10 minutes.

## Claims

1. A diode device comprising the following layers:
an electrospun polymer fiber network layer substrate 1, and on this substrate, arranged in the following sequence: a metallic anode layer 2, a polymer hole transport layer **3** made of Polyvinylcarbazole (PVK), an organometallic light emitting layer 4 made of (8-hydroxyquinoline bis(2-phenylpyridyl) iridium (III) complex (IrQ(ppy)₂), a lithium fluoride buffer layer 5, and
a cathode layer 6 wherein: the electrospun polymer fiber network layer substrate is polymethyl methacrylate fiber network layer and has a thickness between 0.7-1.5 µm and an optical transmission of 70-90%,
the metallic anode layer **2** has a thickness between 50-100 nm,
the **PVK** hole transport layer **3** has a thickness between 40-60 nm,
the the IrQ(ppy)₂ organometallic light emitting layer **4** has a thickness between 50-80 nm,
the lithium fluoride buffer layer **5** has a thickness between 0.8 - 1.5 nm,
the cathode layer is Al **6** and has a thickness between 100-150 nm.

2. Diode device according to any of the claim 1 wherein the material for the metallic anode layer **2** is selected from an Au, Ag, Ni or ITO.

3. Diode device according to any of claims 1 to 2 further comprising a flexible transparent substrate in contact with the electrospun polymer fiber network layer substrate.

4. Diode device according to claim 3 wherein the flexible transparent substrate is selected from Polyethylene terephthalate (PET), Polyethylene naphthalate (PEN), Poly-dimethyl siloxane (PDMS), polyimides (PI), bacterial cellulose or paper.

5. A process for manufacturing a diode device according to any of the claims 1 or 2, comprising the steps of:
- providing a stainless-steel frame collector on which a multilayer sandwich structure is built in the following sequence:
- providing an electrospun polymer fiber network layer substrate **1** on top of the collector by an electrospinning process, using a precursor polymer solution;
- depositing a first metallic layer on one side of the electrospun polymer fiber network layer substrate through a shadow mask, partially covering the electrospun fiber network layer substrate, as a metallic anode layer **2;**
- depositing a polymer hole transport layer **3** made of Polyvinylcarbazole (PVK) on the first metallic layer, through a shadow mask, partially covering the first metallic layer, through thermal vacuum evaporation with the specific parameters: pressure: 1 - 3 x 10⁻⁶ mbar, current ranging from 50-80 A, voltage ranging from 0.665-1V, and a deposition time of 10-15 minutes;
- depositing **an** organometallic light emitting layer **4** made of (8-hydroxyquinoline bis(2-phenylpyridyl) iridium (III) complex (IrQ(ppy)₂) on the PVK hole transport layer by thermal vacuum evaporation with the specific parameters: pressure of 1-3x10⁻⁶ mbar, current: 52 - 57 A, voltage: 0.6 - 0.7 V, and a deposition time:15-20 minutes, through a shadow mask, over the same overlapping surface as of the PVK hole transport layer surface,
- depositing a buffer layer 5 of lithium fluoride on the (IrQ(ppy)₂) light emitting layer, through a shadow mask, partially overlapping the light emitting layer,
- depositing a second metallic layer, over the same overlapping surface area of the buffer lithium fluoride layer surface, through a shadow mask, to serve as a metallic cathode layer **6,** and
- removing the stainless-steel frame collector.

6. Process according to claim 5, further comprising
- before the step of removing the stainless-steel frame collector the intermediate steps of:
- heating a flexible transparent substrate at 130-170°C,
- attaching the flexible transparent substrate to the electrospun polymer fiber network layer substrate **1,**
- maintaining at the same temperature above, for 5 minutes, the heating of the attached flexible transparent substrate, and
- after removing the stainless-steel frame collector the supplementary step of:
- continue heating the flexible transparent substrate with the attached multilayer sandwich structure at 130-170°C for 10 minutes.

7. Use of a diode device according to claims 3 and 4, in an electronic display.

## Patentansprüche

1. Diodenvorrichtung, bestehend aus folgenden Schichten:
einem elektrogesponnenen Polymerfasernetzwerkschicht 1 als Substrat und darauf Schichten in folgender Reihenfolge angeordnet:
einer metallischen Anodenschicht 2, einer Polymer-Lochtransportschicht 3 aus Polyvinylcarbazol (PVK), einer Ir(III)- Komplex - (8-Hydroxychinolin-bis(2-phenylpyridyl)-iridium - orgonometallischen Emissionsschicht, (IrQ(ppy)₂), 4,
einer Lithiumfluorid-Pufferschicht 5, und
einer Kathodenschicht 6, wobei: das Substrat der elektrogesponnenen Polymerfasernetzwerkschicht aus Polymethylmethacrylat besteht und eine Dicke zwischen 0,7 und 1,5 µm sowie eine optische Transmission von 70-90 % aufweist,
die metallische Anodenschicht 2 eine Dicke zwischen 50 und 100 nm aufweist,
die PVK-Lochtransportschicht 3 eine Dicke zwischen 40 und 60 nm aufweist,
die IrQ(ppy)₂ organometallischen Emissionsschicht 4 eine Dicke zwischen 50-80 nm aufweist,
die Lithiumfluorid-Pufferschicht 5 eine Dicke zwischen 0,8 und 1,5 nm aufweist,
die Kathodenschicht aus Al 6 besteht und die Schicht eine Dicke zwischen 100 und 150 nm aufweist.

2. Diodenvorrichtung nach einem der Ansprüche 1, wobei das Material für die metallische Anodenschicht 2 aus Au, Ag, Ni oder ITO ausgewählt ist.

3. Diodenvorrichtung nach einem der Ansprüche 1 oder 2, ferner umfassend ein flexibles, transparentes Substrat, das mit dem Substrat der elektrogesponnenen Polymerfasernetzwerkschicht in Kontakt steht.

4. Diodenvorrichtung nach Anspruch 3, wobei das flexible, transparente Substrat ausgewählt ist aus Polyethylenterephthalat (PET), Polyethylennaphthalat (PEN), Polydimethylsiloxan (PDMS), Polyimiden (PI), Bakterienzellulose oder Papier.

5. Verfahren zur Herstellung einer Diodenvorrichtung nach einem der Ansprüche 1 oder 2, umfassend die folgenden Schritte:
- Bereitstellung eines Edelstahlrahmenkollektors, auf dem eine mehrschichtige Sandwichstruktur in folgender Reihenfolge aufgebaut ist:
- Bereitstellung einer elektrogesponnenen Polymerfasernetzwerkschicht 1 als Substrat auf den Kollektor durch ein Elektrospinnenverfahren unter Verwendung einer Vorläuferpolymerlösung;
- Aufbringen einer ersten Metallschicht auf eine Seite des Substrats der elektrogesponnenen Polymerfasernetzwerkschicht mittels einer Schattenmaske, wobei das Substrat der elektrogesponnenen Fasernetzwerkschicht teilweise bedeckt wird, als metallische Anodenschicht 2;
- Aufbringen einer Polymer-Lochtransportschicht 3 aus Polyvinylcarbazol (PVK) auf die erste Metallschicht durch thermische Vakuumverdampfung mittels einer Schattenmaske, wobei die erste Metallschicht teilweise bedeckt wird, mit folgenden Parametern: Druck: 1 - 3 x 10⁻⁶ mbar, Stromstärke: im Bereich von 50-80 A, Spannung: im Bereich von 0,665-1 V, und eine Abscheidungszeit: 10-15 Minuten;
- Aufbringen einer Ir(III) - Komplex - (8-Hydroxychinolin-bis(2-phenylpyridyl)- iridium - orgonometallischen Emissionsschicht, (IrQ(ppy)₂), 4, auf der PVK-Lochtransportschicht durch thermische Vakuumverdampfung mit den spezifischen Parametern: Druck von 1-3x10⁻⁶ mbar, Stromstärke: 52 - 57 A, Spannung: 0,6 - 0,7 V und eine Abscheidungszeit von 15-20 Minuten, durch eine Schattenmaske, über die gleiche überlappende Fläche wie die Oberfläche der PVK-Lochtransportschicht;
- Aufbringen einer Pufferschicht 5 aus Lithiumfluorid auf der (IrQ(ppy)₂)-Emissionschicht,
durch eine Schattenmaske, worbei die Emissionschicht teilweise überlappt wird;
- Aufbringen einer zweiten Metallschicht, über die gleiche überlappende Fläche wie die Oberfläche der Lithiumfluorid-Pufferschicht, durch eine Schattenmaske, die als metallische Kathodenschicht 6 dient, und
- Ausbau des Edelstahlrahmenkollektors.

6. Verfahren nach Anspruch 5, ferner umfassend
- vor dem Schritt des Ausbaus des Edelstahlrahmenkollektors die Zwischenschritte:
- Erhitzen eines flexiblen transparenten Substrats auf 130-170 °C,
- Anbringen des flexiblen transparenten Substrats an das Substrat der elektrogesponnenen Polymerfasernetzwerkschicht 1,
- die Erwärmung des aufgebrachten flexiblen transparenten Substrats 5 Minuten lang auf der oben genannten Temperatur halten, und
- nach dem Entfernen des Edelstahlrahmenkollektors der zusätzliche Schritt:
- weiteres Erhitzen des flexiblen transparenten Substrats mit der angebrachten Mehrschicht-Sandwichstruktur 10 Minuten lang auf 130-170 °C.

7. Verwendung einer Diodenvorrichtung nach die Ansprüche 3 und 4 in einem elektronischen Anzeige.

## Revendications

1. Dispositif à diode comprenant les couches suivantes:
un substrat 1 constitué d'un réseau de fibres polymères électrofilées, sur lequel sont disposes la séquence suivante: une couche d'anode métallique 2, une couche de transport de trous polymère 3 en polyvinylcarbazole (PVK), une couche émettrice de lumière organométallique d'iridium complexe Ir(III) (8-hydroxyquinoléine bis(2-phénylpyridyl) iridium), (IrQ(ppy)₂), 4,
une couche tampon de fluorure de lithium 5, et
une couche de cathode 6; dans lequel le substrat constitué d'un réseau de fibres polymères électrofilées est en polyméthacrylate de méthyle et présente une épaisseur comprise entre 0,7 et 1,5 µm et une transmission optique de 70 à 90 %,
la couche d'anode métallique 2 a une épaisseur comprise entre 50 et 100 nm,
la couche de transport de trous en PVK 3 a une épaisseur comprise entre 40 et 60 nm,
la couche émettrice de lumière organométallique IrQ(ppy)₂ 4 a une épaisseur comprise entre 50-80 nm,
la couche tampon de fluorure de lithium 5 a une épaisseur comprise entre 0,8 et 1,5 nm,
la couche de cathode est AI 6 et a une épaisseur comprise entre 100 et 150 nm.

2. Dispositif à diode selon l'une quelconque des revendications 1, dans lequel le matériau de la couche d'anode métallique 2 est choisi parmi Au, Ag, Ni ou ITO.

3. Dispositif à diode selon l'une quelconque des revendications 1 ou 2, comprenant en outre un substrat transparent flexible en contact avec le substrat de la couche de réseau de fibres polymères électrofilées.

4. Dispositif à diode selon la revendication 3, dans lequel le substrat transparent flexible est choisi parmi le téréphtalate de polyéthylène (PET), le naphtalate de polyéthylène (PEN), le polydiméthylsiloxane (PDMS), les polyimides (PI), la cellulose bactérienne ou le papier.

5. Procédé de fabrication d'un dispositif à diode selon l'une quelconque des revendications 1 ou 2, comprenant les étapes suivantes:
- fournir un collecteur à cadre en acier inoxydable sur lequel est construite une structure sandwich multicouche selon la séquence suivante:
- fournir un substrat de couche de réseau de fibres polymères électrofilées 1 sur le collecteur par un procédé d'électrofilage, à partir d'une solution de polymère précurseur;
- dépôt d'une première couche métallique sur une face du substrat de la couche de réseau de fibres polymères électrofilées, à travers un masque d'ombrage, recouvrant partiellement le substrat de la couche de réseau de fibres électrofilées, formant ainsi une couche d'anode métallique 2;
- dépôt d'une couche de transport de trous polymère 3 en polyvinylcarbazole (PVK) sur la première couche métallique, à travers un masque d'ombrage, recouvrant partiellement la première couche métallique, par évaporation thermique sous vide avec les paramètres suivants: pression: 1 à 3 × 10⁻⁶ mbar, courant: 50 à 80 A, tension: 0,665 à 1 V, et durée de dépôt: 10 à 15 minutes;
- dépôt d'une couche organométallique émettrice de lumière 4, composée d'un complexe Ir(III) (8-hydroxyquinoléine bis(2-phénylpyridyl) iridium), (IrQ(ppy)₂),s sur la couche de transport de trous PVK par évaporation thermique sous vide avec les paramètres suivants: pression de 1 à 3 × 10⁻⁶ mbar, courant: 52 à 57 A, tension: 0,6 à 0,7 V et durée de dépôt: 15 à 20 minutes, à travers un masque d'ombrage, sur la même surface de recouvrement que la surface de la couche de transport de trous PVK,
- dépôt d'une couche tampon 5 de fluorure de lithium sur la couche émettrice de lumière (IrQ(ppy)₂), à travers un masque d'ombrage, chevauchant partiellement la couche émettrice de lumière,
- dépôt d'une seconde couche métallique, sur la même surface de recouvrement que la couche tampon de fluorure de lithium, à travers un masque d'ombrage, pour servir de couche de cathode métallique 6, et
- retrier le collecteur à cadre en acier inoxydable.

6. Procédé selon la revendication 5, comprenant en outre
- avant l'étape de retrait du collecteur à cadre en acier inoxydable, les étapes intermédiaires sont les suivantes:
- chauffer un substrat transparent flexible à 130-170 °C,
- fixation du substrat transparent flexible au substrat de la couche de réseau de fibres polymères électrofilées 1,
- maintenant à la même température que ci-dessus, pendant 5 minutes, le chauffage du substrat transparent flexible attaché, et
- après avoir retiré le collecteur à cadre en acier inoxydable, l'étape supplémentaire consiste à:
- continuer à chauffer le substrat transparent flexible avec la structure sandwich multicouche attaché à 130-170 °C pendant 10 minutes.

7. Utilisation d'un dispositif à diode selon les revendications 3 et 4, dans un écran électronique.
